## Europäisches Patentamt

## European Patent Office

## Office européen des brevets

(19)

(11) Veröffentlichungsnummer : **0 068 185**
**B1**

# EUROPÄISCHE PATENTSCHRIFT

(12)

(45) Veröffentlichungstag der Patentschrift :
20.02.85

(21) Anmeldenummer : **82104967.3**

(22) Anmeldetag : **07.06.82**

(51) Int. Cl.⁴ : **H 03 G   7/00**

(54) **Schaltungsanordnung zur Erzeugung einer von einer Wechselspannung abhängigen Steuergleichspannung.**

(30) Priorität : **19.06.81 DE 3124289**

(43) Veröffentlichungstag der Anmeldung :
**05.01.83 Patentblatt 83/01**

(45) Bekanntmachung des Hinweises auf die Patenterteilung : **20.02.85 Patentblatt 85/08**

(84) Benannte Vertragsstaaten :
**AT BE CH DE FR GB IT LI LU NL SE**

(56) Entgegenhaltungen :
**DE-B- 2 830 784**
**WISSENSCHAFTLICHE BERICHTE AEG TELEFUN-
KEN, Band 52, Nr. 1/2, Januar 1979, Seiten 97-104,
Berlin (DE);
TECHNISCHE RUNDSCHAU, Band 72, Nr. 41, 14.
Oktober 1980, Seiten 9 und 13, Bern (CH);
FUNKSCHAU, Band 52, Nr. 17, 14. August 1980,
Seiten 67-71, München (DE);**

(73) Patentinhaber : **Licentia Patent-Verwaltungs-GmbH
Theodor-Stern-Kai 1
D-6000 Frankfurt/Main 70 (DE)**

(72) Erfinder : **Schröder, Ernst, Dipl.-Ing.
Pinkenburger Strasse 25D
D-3000 Hannover 51 (DE)**

(74) Vertreter : **Einsel, Robert, Dipl.-Ing.
Theodor-Stern-Kai 1
D-6000 Frankfurt/Main 70 (DE)**

## Beschreibung

Die Erfindung bezieht sich auf eine Schaltungsanordnung zur Erzeugung einer von einer Wechselspannung abhängigen Steuergleichspannung, wie sie im Oberbegriff des Anspruchs 1 wiedergegeben ist.

Aus der DE-AS 28 30 784 ist bekannt, eine solche Schaltungsanordnung bei einem Kompandersystem zu verwenden.

Für eine gute Funktion eines Kompandersystems ist eine kurze Ausschwingzeit notwendig, um nach abrupt endendem Nutzsignal hörbare Rauschfahnen zu vermeiden. Andererseits führt eine kurze Ausschwingzeit bei tieffrequentem Nutzsignal zu einer hohen Welligkeit der Regelspannung und damit über die Regelung zu einer Signalverzerrung. Zur Vermeidung dieser Signalverzerrungen ist daher eine lange Ausschwingzeit erforderlich. Diese sich entgegenstehenden Forderungen werden durch eine Zeitkonstantenumschaltung erfüllt. Die Umschaltung wird kompressorseitig vom Wechselspannungs-Ausgangssignal und expanderseitig vom Wechselspannungs-Eingangssignal bewirkt.

Die Ladezeitkonstantenumschaltung wird z. B. durch ein retriggerbares Monoflop bewirkt, wie es in « Wissenschaftliche Berichte AEG-TELEFUNKEN » Bd. 52 (1979), Seite 103 beschrieben ist.

Bei dieser Schaltung wird ein Kondensator über eine Stromquelle aufgeladen. Ein Eingang eines Differenzverstärkers ist mit dem Kondensator verbunden, der andere Eingang mit einer Referenzspannung. Die Aufladung des Kondensators bewirkt zunächst eine Zeitverzögerung. Erreicht die Kondensatorspannung schließlich die Höhe der Referenzspannung, so wird der Differenzverstärker sehr schnell umgeschaltet. Dies geschieht in einem Bereich von ca. 50 mVolt. Die durch diese Schaltung bewirkte Umschaltung einer Regelzeitkonstante erfolgt daher sehr schnell.

Dieses schlagartige Umschalten der Zeitkonstante macht sich dann hörbar bemerkbar, wenn durch Toleranzen des zeitbestimmenden Kondensators oder/und dessen Aufladestroms die Umschaltzeitpunkte der Zeitkonstanten im Kompressor und im Expander nicht übereinstimmen.

Aufgabe der Erfindung ist es, Toleranzeinflüsse der zeitbestimmenden glieder der bekannten Schaltung mit geringem Aufwand zu reduzieren.

Die Erfindung bezieht sich auf die im Oberbegriff des Anspruchs 1 wiedergegebene Schaltungsanordnung. Die genannte Aufgabe wird bei einer solchen Schaltungsanordnung durch die im Kennzeichen des Anspruchs 1 wiedergegebenen Merkmale gelöst.

Die Erfindung wird nun anhand von Ausführungsbeispielen, die in den Zeichnungen dargestellt sind, näher erläutert.

Es zeigen :

Figur 1   einen Aufbau der erfindungsgemäßen Schaltung,

Figur 2   einen anderen Aufbau der erfindungsgemäßen Schaltung,

Figur 3   Zeitdiagramme zur Erläuterung der Erfindung,

Figur 3a   den Verlauf einer Signalspannung an Klemme 1,

Figur 3b   die Kondensatorspannung des Kondensators 7,

Figur 3c   den Stromverlauf durch den Transistor 21,

Figur 3d   den Verlauf der Steuerspannung an Klemme 2.

Figur 4   einen dritten Aufbau der erfindungsgemäßen Schaltung.

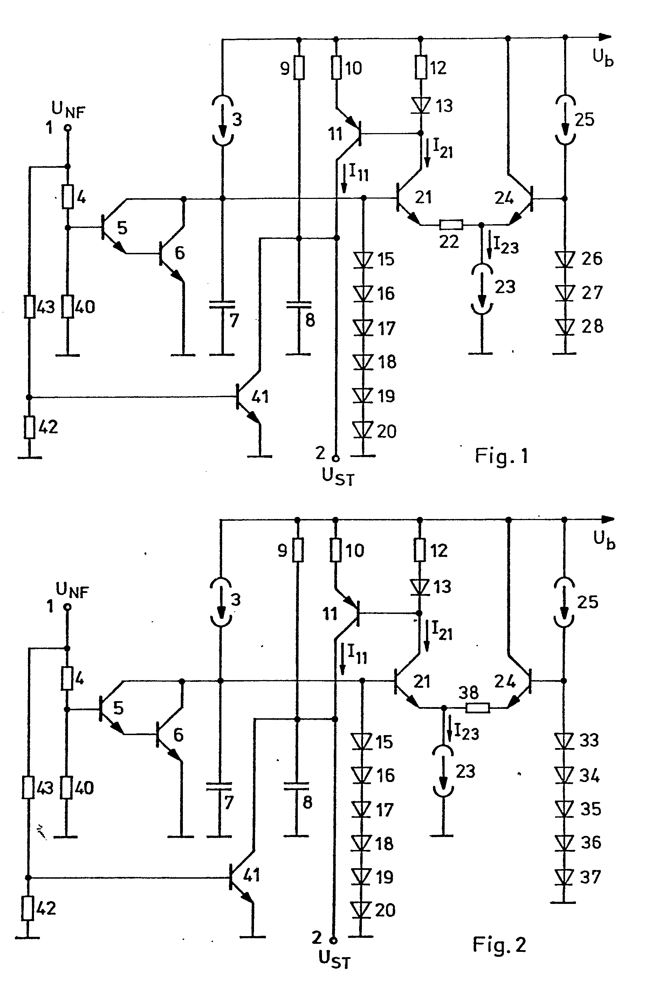

In Fig. 1 ist der Aufbau einer erfindungsgemäßen Schaltung dargestellt. Sie hat einen Eingang 1 für die Wechselspannung $U_{NF}$ und einen Ausgang 2 für die Steuergleichspannung $U_{ST}$. Der Eingang 1 steuert über einen Spannungsteiler 4, 40 die Basis der als Darlington-Schaltung geschalteten Transistoren 5 und 6 an. Der Emitter des Transistors 6 liegt auf Bezugspotential. Die Kollektoren der Transistoren 5 und 6 sind mit den ersten Anschlüssen der Stromquelle 3, des Kondensators 7, der Diodenstrecke 15-20 und der Basis des Transistors 21 verbunden. Der Kondensator 7 und die Diodenstrecke 15-20 liegen mit dem zweiten Anschluß auf Bezugspotential. Der Transistor 21 bildet mit dem Transistor 24 einen Differenzverstärker. Der Emitter des Transistors 21 ist über den Gegenkopplungswiderstand 22 mit dem Emitter des Transistors 24 und dem ersten Anschluß der Stromquelle 23 verbunden. Der zweite Anschluß der Stromquelle 23 liegt auf Bezugspotential. Der Kollektor des Transistors 24 hat Verbindung mit der Betriebsspannung $U_b$. Die Basis des Transistors 24 hat einen gemeinsamen Kontakt mit der Diodenstrecke 26-28 und der Stromquelle 25. Der zweite Anschluß der Diodenstrecke führt auf Bezugspotential, der zweite Anschluß der Stromquelle 25 auf die Betriebsspannung $U_b$. Der Kollektor des Transistors 21 ist mit der Basis des Transistors 11 und außerdem über die Reihenschaltung der Diode 13 und des Widerstandes 12 mit der Betriebsspannung $U_b$ verbunden. Der Emitter des Transistors 11 liegt über den Widerstand 10 an der Betriebsspannung $U_b$.

Über einen weiteren Spannungsteiler 43, 42 wird vom Eingang 1 die Basis des Transistors 41 angesteuert, dessen Emitter auf Bezugspotential liegt und dessen Kollektor mit dem Verbindungspunkt von Kondensator 8 und Widerstand 9 verbunden ist. Über den Widerstand 9 wird der Kondensator 8 aus der Betriebsspannung aufgeladen. Mit seinem zweiten Kontakt liegt der Kondensator 8 auf Bezugspotential. Der Kollektor des Transistors 11 führt auf den gemeinsamen Verbindungspunkt des Widerstandes 9, des Kondensators 8, des Kollektors 4 und des Ausganges 2.

Die Transistoren 5, 6 und 41 stellen jeweils Schwellwertschalter dar : Überschreitet die Eingangsspannung an Eingang 1 einen durch die Basis-Emitterspannung des Transistors 41 und den Spannungsteiler 43, 42 vorgegebenen Schwellwert, so wird die Kollektor-Emitterstrecke des Transistors 41 leitend. Als Folge davon wird der Kondensator 8 über den Kollektor-Emitter Widerstand des Transistors 41 zu negativeren Werten entladen und die Ausgangsspannung am Anschluß 2 wird negativer. Sinkt die Eingangsspannung wieder unter den Schwellwert, wird der Transistor 41 wieder gesperrt und der Kondensator 8 über den Widerstand 9 wieder zu positiveren Werten aufgeladen. Somit wird die Ausgangsspannung an 2 positiver.

Die Bauelemente 8, 9, 41, 42 stellen insoweit eine schnelle Gleichrichterschaltung dar, wie sie in DE-PS 24 06 258 Fig. 12 und DE-AS 24 03 799 Fig. 2 beschrieben ist.

Der weitere Schwellwertschalter aus den Transistoren 5, 6, und dem Spannungsteiler 4, 40 wirkt als Entladestrompfad parallel zum Kondensator 7. Liegt am Eingang 1 ein Signal an, das größer ist als der Schwellwert der Anordnung 4, 40, 5, 6 so wird der Kondensator 7 über die Darlington-Schaltung 5 und 6 sehr schnell entladen bis auf eine Restspannung von ca. einer Diodenspannung. Dadurch ist die Spannung an der Basis des Transistors 24 um zwei Diodenspannungen höher als die an der Basis des Transistors 21. Dieser ist somit gesperrt, sein Kollektorstrom $I_{21}$ ist Null und damit auch der Ausgangsstrom $I_{11}$ der Stromspiegelschaltung 10, 11, 12, 13. Für die Aufladung des Kondensators 8 ist damit nur der Ladestrom durch den Widerstand 9 wirksam. Es ergibt sich die große Zeitkonstante aus dem Produkt des Kondensators 8 und des Widerstandes 9. Unterschreitet das Signal am Eingang 1 die Schwellspannung der Anordnung 4, 40, 5, 6, so ist die Darlington-Schaltung 5, 6 gesperrt. Die Kondensatorspannung des Kondensators 7 erhöht sich dann linear, hervorgerufen durch die Stromquelle 3, von einer Diodenspannung auf einen durch die sechs Dioden 15-20 begrenzten Wert. Die Zeit, die vergeht, bis der Kondensator 7 und damit die Basis des Transistors 21 drei Diodenspannungen, d. h. die gleiche Spannung wie die Basis des Transistors 24 erreicht, ist die Verzögerungszeit oder Haltezeit der Schaltung. Nach Erreichen dieser Spannung an seiner Basis übernimmt der Transistor 21 kontinuierlich den Strom $I_{23}$ der Stromquelle 23, bis der Strom $I_{23}$ bei z. B. 5 Diodenspannungen ganz vom Transistor 21 übernommen wird, und der Transistor 24 sperrt. Der Übernahmespannungsbereich ist gleich dem Produkt des Gegenkopplungswiderstandes 22 und des Stromes $I_{23}$. Die Stromübernahme durch den Transistor 21 ist proportional der Kondensatorspannung des Kondensators 7. Die Zeit der Stromübernahme liegt in der Größenordnung der Zeitverzögerung der Schaltung. Gleichzeitig wird der Anstieg des Stromes $I_{21}$ im Transistor 21 von der Stromspiegelschaltung, die aus den Widerständen 10 und 12, der Diode 13 und dem Transistor 11 besteht, als Strom $I_{11}$ dem Kondensator 8 zugeführt. Der Strom $I_{11}$ wird nach $I_{11max} = I_{23} \cdot R_{12}/R_{10}$ eingestellt. Der konstant ansteigende Strom $I_{11}$ bewirkt im Gegensatz zu DE-AS 28 30 784 eine Verrundung des Verlaufs der Steuerspannung am Ausgang 2. Fig. 2 zeigt eine andere Ausführungsform der erfindungsgemäßen Schaltung. Der Gegenkopplungswiderstand 22 entfällt, dafür ist ein Gegenkopplungswiderstand 22 entfällt, dafür ist ein Gegenkopplungswiderstand 38 im Emitterzweig des Transistors 24 vorgesehen. Die Diodenstrecke 26-28 wird durch die Diodenstrecke 33-37 ersetzt.

Bei dieser Schaltung beginnt die Stromübernahme durch den Transistor 21, wenn seine Basisspannung einen Wert erreicht hat, der der Basisspannung des Transistors 24 abzüglich der sich durch den Strom $I_{23}$ durch den Widerstand $R_{38}$ ergebenden Spannung $I_{23} \cdot R_{38}$ entspricht. Der Bereich der Stromübernahme entspricht dem Produkt $I_{23} \cdot R_{38}$.

Die Diodenstrecke an der Basis des Transistors 21 kann auch durch eine entsprechende Zenerdiode ersetzt werden da sie nur dazu dient, die Spannung des Kondensators 7 oberhalb eines Wertes, der zurvollen Stromübernahme durch den Transistor 21 erforderlich ist, zu begrenzen. Sie kann auch entfallen, dann steigt die Spannung am Kondensator bis zur Betriebspannung an.

Ebenso können die Diodenstrecken 26-28 und 33-37 und die Stromquelle 25 durch andere geeignete Schaltungen ersetzt werden, die eine im wesentlichen konstante Spannung an der Basis des Transistors 24 erzeugen.

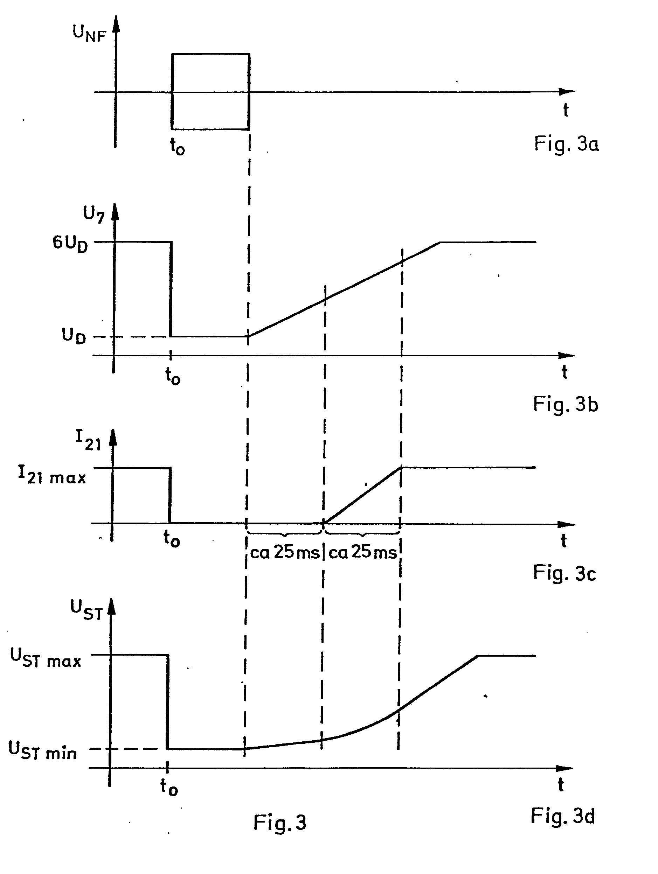

Ist ein Signal beginnend bei $t = T_0$ — entsprechend Fig. 3a — vorhanden, das größer ist als die Schwellspannung der Anordnung 4, 5, 6, 40, so ist die Darlington-Schaltung 5, 6 während der Signaldauer leitend geschaltet. Die Kondensatorspannung $U_7$ beträgt nach Fig. 3b ca. eine Diodenspannung. Der Strom durch den Transistor 21 wird nach Fig. 3a ebenfalls den Schwellwert der Anordnung 41, 42, 43, wird der Konsensator 8 ebenfalls entladen. Die Steuerspannung des Ausgangs 2 hat ihren minimalen Wert. Wird das Signal $U_{NF}$ Null oder sinkt es unter die jeweiligen Schwellspannungen, werden die Transistoren 5, 6, 41 gesperrt. Die Kondensatorspannung $U_7$ steigt dann kontinuierlich auf den durch die Dioden 15-20 gegrenzten Wert an. Wie aus Fig. 3c ersichtlich, beginnt der Strom $I_{21}$ zu fließen, sobald die Kondensatorspannung $U_7$ den Wert von drei Diodenspannungen erreicht hat. Der Strom $I_{21}$ steigt dann proportional der Kondensatorspannung $U_7$ von Null auf seinen Maximalwert an. Den dabei entstehenden Spannungsverlauf am Ausgang 2 zeigt Fig. 3d. Während der Haltezeit der Schaltung steigt die Steuerspannung $U_{ST}$ langsam an. Der Anstieg wird durch die große Zeitkonstante, gebildet aus Kondensator 8 und Widerstand 9, bestimmt. Nach der Haltezeit tritt eine Verrundung der Steuerspannung $U_{ST}$ ein. Dem Strom, der durch den Widerstand 9 dem Kondensator 8 zugeführt wird, überlagert sich der

konstant ansteigende Strom $I_{11}$, der durch die Stromspiegelschaltung aus dem Strom $I_{21}$ gewonnen wird. Der konstant ansteigende Strom $I_{11}$ bewirk also einen gekrümmten, d. h. verrundeten Anstieg der Steuerspannung. Die Steuerspannung steigt bis zu ihrem Maximalwert. Wird die Steuerspannung auf diese Art gewonnen, so verschieben sich jetzt, bedingt durch die oben angegebenen Toleranzeinflüsse, zwei verrundete Kurven gegeneinander. Der Einfluß dieser Verschiebung ist im Mittel kleiner als in der vorbekannten Schaltung.

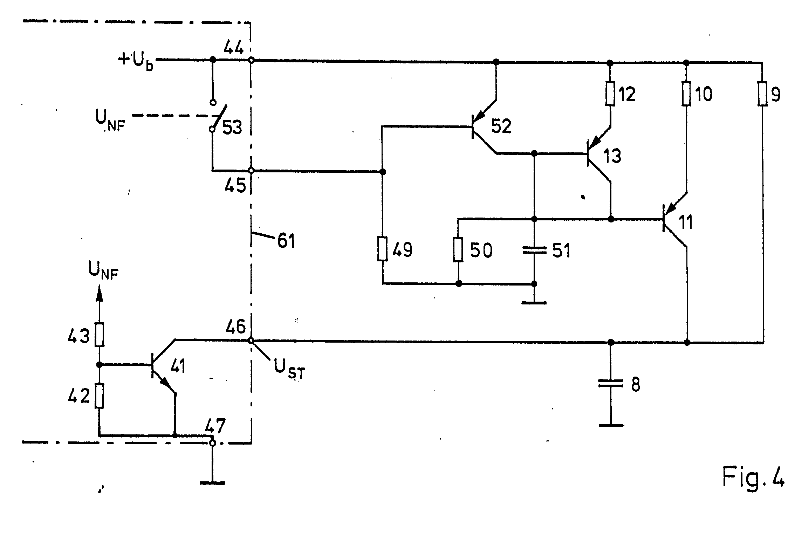

Fig. 4 zeigt ein weiteres Ausführungsbeispiel. Es wird als Peripherieschaltung für das bekannte HIGH-COM IC U401B, hier mit 61 beziffert, verwendet, und bewirkt ebenfalls eine Verundung des Verlaufs der Steuerspannung. Mit einer Anschlußklemme 44 des IC's 61 sind der Emitter eines Transistors 52, über einen Widerstand 12 der Emitter eines Transistors 54, über einen Widerstand 10 der Emitter eines Transistors 11 und ein Anschluß eines Widerstandes 9 verbunden. Der zweite Anschluß des Widerstandes 9 führt auf den Kollektor des Transistors 11, einen Anschluß eines Kondensators 8 und einen Ausgang 46 des IC's 61. Ein Ausgang 45 des IC's 61 ist mit der Basis des Transistors 52 und mit einem Anschluß eines Widerstandes 49 verbunden. Der ander Anschluß des Widerstand 49 führt über die Verbindungspunkte mit einem Widerstand 50 und einem Kondensator 51 auf Bezugspotential. Der Widerstand 50 und der Kondensator 51 bilden eine Parallelschaltung. Der gemeinsame Verbindungspunkt führt auf der einen Seite auf Bezugspotential, auf der anderen Seite ist er mit dem Kollektor des Transistors 52, der Basis des Transistors 54, mit dem Kollektor des Transistors 54 und der Basis des Transistors 11 verbunden. Der mit dem Ausgang 46 des IC's 61 verbundene Kondensator 8 liegt mit seinem zweiten Anschluß auf Bezugspotential. Der Anschluß 47 des IC's 61 ist mit Bezugspotential verbunden. Die Anschlüsse 44 und 45 des IC's 61 weisen intern einen Schalter 53 auf, der von der Signalspannung $U_{NF}$ gesteuertwird. Liegt eine Signalspannung $U_{NF}$ vor, ist der Schalter 53 geöffnet, fällt die Signalspannung $U_{NF}$ unter einen Schwellwert (siehe DE-AS 28 50 736), so wird der Schalter 53 mit einer Zeitverzögerung geschlossen, die durch einen Schaltungsteil in dem IC 61 bewirkt wird (siehe Wissenschaftliche Berichte, AEG-Telefunken 52 (1979) 1-2, S.103). Äquivalent zu den vorhergehenden Ausführungsbeispielen sind in internen Schaltung des IC's 61 die Widerstände 42, 43 und der Transistor 41 vorhanden. An der Klemme 46 des IC's 61 liegt dei Steuerspannung $U_{ST}$ an.

Ist ein Signal $U_{NF}$ vorhanden, dann ist der Schalter 53 geschlossen. Damit wird der Transistor 52 geöffnet und der Kondensator 51 auf + Ub von Klemme 44 gelegt. Der Transistor 11 ist gesperrt, es fließt durch Widerstand 10 und Transistor 11 kein Strom mehr zum Kondensator 8. Ist ein Signal $U_{NF}$ nicht mehr vorhanden, wird der Schalter 53 mit einer Zeitverzögerung geschlossen und damit auch der Transistor 52 geschlossen. Der Kondensator 51 entlädt sich jetzt langsam über den Widerstand 50. Durch die Abnahme der Spannung an der Basis des Transistors 13 wird dieser langsam leitend und es fließt ein konstant ansteigender Strom über den Wirderstand 50 gegen Masse. Im Gleichgewichtszustand stellt sich am Kondensator 51 eine Spannung ein, die durch den Strom bestimmt wird, der durch den Widerstand 12, den Transistor 13 und den Widerstand 50 fließt. Der bis zum Erreichen des Gleichgewichtszustands ansteigende Strom wird durch die Stromspiegelschaltung 10, 11, 12, 13 dem Kondensator 8 zugeführt. Die am Kondensator 8 anliegende Spannung entspricht der Steuerspannung $U_{ST}$. Die Entladeschaltung des Kondensators 8, bestehend aus dem Spannungsteiler 43, 42 und dem Transistor 41, ist so eingestellt, daß sie durch die Spitzen des Signals angesteuert wird. Der Kondensator 8 wirt konstant durch den durch Widerstand 9 vorgegebenen Strom geladen.

## Ansprüche

1. Schaltungsanordnung zur Erzeugung einer von einer Wechselspannung abhängigen Steuergleichspannung, insbesondere zur Dynamik-Kompression oder -Expansion, mit einem ersten Ladekondensator (7, 51), der über einen ersten Ladestromkreis (3, 7, 12, 13, 51) aufladbar und über einen ersten Entladestromkreis (4, 40, 5, 6, 7, 52, 51) entladbar ist, und einem zweiten Ladekondensator (8), der über einen zweiten Ladestromkreis (8, 9) und einem dazu parallelen dritten Ladestromkreis (8, 10, 11) aufladbar und über einen zweiten Entladestromkreis (41, 42, 43, 8) entladbar ist, wobei der dritte Ladestromkreis (8, 10, 11) einen steuerbaren Strompfad (10, 11) aufweist, der beim Überschreiten der Spannung des ersten Ladekondensators (7, 51) über einen vorgegebenen Schwellwert angesteuert wird, dadurch gekennzeichnet, daß der Ladestrom des dritten Ladestromkreises (8, 10, 11) bei einer Spannung ($U_7$) des ersten Ladekondensators (7, 51) unterhalb des Schwellwertes einen ersten Wert und oberhalb des Schwellwertes einen zweiten Wert aufweist, wobei der erste oder zweite Wert zu der Spannung des ersten Ladekondensators (7, 51) bis zu einem Grenzwert proportional ist, und der Bereich des ersten Wertes sich an den Bereich des zweiten Wertes unmittelbar anschließt.

2. Schaltungsanordnung nach Anspruch 1, dadurch gekennzeichnet, daß der dritte Ladestromkreis (8, 10, 11) einen ersten Zweig (10, 11) einer Stromspiegelschaltung (10, 11, 12, 13) bildet, wobei der Strom im zweiten Zweig (12, 13) der Stromspiegel schaltung durch die Höhe der Spannung des ersten Ladekondensators (7, 51) bestimmt ist.

3. Schaltungsanordnung nach Anspruch 1, dadurch gekennzeichnet, daß der Strom des zweiten Zweiges (12, 13) der Stromspiegelschaltung (10, 11, 12, 13) über einen gegengekoppelten Verstärker geführt ist.

4. Schaltungsanordnung nach Anspruch 3, dadurch gekennzeichnet, daß der Verstärker als Differenzverstärker mit einem ersten (21) und einem zweiten Transistor (24) ausgeführt ist.

5. Schaltungsanordnung nach Anspruch 4, dadurch gekennzeichnet, daß der zweite Zweig (12, 13) der Stromspiegelschaltung (10, 11, 12, 13) den Kollektorkreis des ersten Transistors (21) des Differenzverstärkers bildet, dessen Basis mit dem ersten Ladekondensator (7) verbunden ist.

6. Schaltungsanordnung nach Anspruch 4, dadurch gekennzeichnet, daß die beiden Emitter beider Transistoren des Differenzverstärkers über einen Widerstand (22, 38) zusammengeschaltet sind.

7. Schaltungsanordnung nach Anspruch 6, dadurch gekennzeichnet, daß der Emitter einer der beiden Transistoren über eine Stromquelle (23) nach Masse geschaltet ist.

8. Schaltungsanordnung nach Anspruch 4, dadurch gekennzeichnet, daß der Übergangswert des Bereichs des ersten Wertes zum Bereich des zweiten Wertes des Ladestroms des dritten Ladestromkreises (8, 10, 11) durch die Vorspannung der Basis des zweiten Transistors (24) des Differenzverstärkers gegeben ist.

9. Schaltungsanordnung nach Anspruch 1, dadurch gekennzeichnet, daß die Spannung des ersten Ladekondensators (7) durch eine Begrenzungsschaltung (15-20) begrenzt ist.

10. Schaltungsanordnung nach Anspruch 1, dadurch gekennzeichnet, daß der Ladestrom des dritten Ladestromkreises (8, 10, 11) unterhalb des Schwellwertes der Spannung am ersten Ladekondensator (7) nahezu Null ist.

11. Schaltungsanordnung nach Anspruch 1, dadurch gekennzeichnet, daß der Ladestrom des dritten Ladestromkreises (8, 10, 11) oberhalb des Schwellwertes der Spannung am ersten Ladekondensator (51) nahezu Null ist.

**Claims**

1. Control arrangement for the production of a d.c. control voltage dependent on an alternating voltage, especially for dynamic-compression or -expansion, having a first storage condenser (7, 51), which is chargeable by way of a first charging circuit (3, 7, 12, 13, 51) and is dischargeable by way of a first discharging circuit (4, 40, 5, 6, 7, 52, 51), and a second storage condenser (8) which is chargeable by way of a second charging circuit (8, 9) and a third charging circuit (8, 10, 11) parallel thereto, and is dischargeable by way of a second discharging circuit (41, 42, 43, 8), the arrangement being such that the third charging circuit (8, 10, 11) exhibits a controllable current path (10, 11) which is activated in the event of the voltage of the first storage condenser (7, 51) overstepping a predetermined threshold value, characterized by the fact that the charging current of the third charging circuit (8, 10, 11) exhibits a first value on the occurrence of a voltage ($U_7$) of the first storage condenser (7, 51) which is below the threshold value and a second value on the occurrence of a voltage ($U_7$) of the first storage condenser (7, 51) which is above the threshold value, whereby the first or second value is proportional to the voltage of the first storage condenser (7, 51) up to a limiting value, and the range of the first value is directly adjoined to the range of the second value.

2. Control arrangement according to Claim 1, characterized by the fact that the third charging circuit (8, 10, 11) constitutes a first branch (10, 11) of a current mirror circuit (10, 11, 12, 13), whereby the current in the second branch (12, 13) of the current mirror circuit is determined by the level of the voltage of the first storage condenser (7, 51).

3. Control arrangement according to Claim 1, characterized by the fact that the current of the second branch (12, 13) of the current mirror circuit (10, 11, 12, 13) is conducted by way of a counter coupled amplifier.

4. Control arrangement according to Claim 3, characterized by the fact that the amplifier is realised as a differential amplifier with a first (21) and a second transistor (24).

5. Control arrangement according to Claim 4, characterized by the fact that the second branch (12, 13) of the current mirror circuit (10, 11, 12, 13) constitutes the collector circuit of the first transistor (21) of the differential amplifier, the base of which is coupled with the first storage condenser (7).

6. Control arrangement according to Claim 4, characterized by the fact that both of the emitters of the two transistors of the differential amplifier are connected together by a resistance (22, 38).

7. Control arrangement according to Claim 6, characterized by the fact that the emitter of one of the two transistors is connected by way of a current source (23) to chassis.

8. Control arrangement according to Claim 4, characterized by the fact that the transition value from the range of the first value to the range of the second value of the charging current of the third charging circuit (8, 10, 11) is set by the bias of the base of the second transistor (24) of the differential amplifier.

9. Control arrangement according to Claim 1, characterized by the fact that the voltage of the first storage condenser (7) is limited by a limiting circuit (15-20).

10. Control arrangement according to Claim 1, characterized by the fact that the charging current of the third charging circuit (8, 10, 11) is nearly zero beneath the threshold value of the voltage at the first storage condenser (7).

11. Control arrangement according to Claim 1, characterized by the fact that the charging current of the third charging circuit (8, 10, 11) is nearly zero above the threshold value of the voltage at the first storage condense (51).

**Revendications**

1. Circuit délivrant une tension continue de commande fonction d'une tension alternative, en particulier pour la compression ou l'extension de la dynamique, avec un premier condensateur de charge (7, 51), qui se charge par un premier circuit de charge (3, 7, 12, 51, 54) et se décharge sur un premier circuit de décharge (4, 40, 5, 6, 7, 52, 51), et un second condensateur de charge (8), qui se charge par un second circuit de charge (8, 9) et un troisième circuit de charge (8, 10, 11) en parallèle avec le précédent, et se décharge sur un second circuit de décharge (41, 42, 43, 8), le troisième circuit de charge (8, 10, 11) comportant un circuit de courant commandé (10, 11) qui, lors du dépassement de la tension aux bornes du premier condensateur de charge (7, 51), est commandé au-delà d'un seuil prédéterminé, ledit circuit étant caractérisé en ce que le courant de charge du troisième circuit de charge (8, 10, 11) présente une première valeur pour une tension ($U_7$) aux bornes du premier condensateur de charge (7, 51) inférieure au seuil et une seconde valeur au-delà du seuil, la première ou seconde valeur étant proportionnelle à la tension aux bornes du premier condensateur de charge (7, 51) jusqu'à une valeur limite, et la plage de la première valeur se raccordant directement à celle de la seconde valeur.

2. Circuit selon revendication 1, caractérisé en ce que le troisième circuit de charge (8, 10, 11) constitue la première branche (10, 11) d'un circuit inverseur de courant (10, 11, 12, 13), le courant dans la seconde branche (12. 13) dudit circuit inverseur étant déterminé par la valeur de la tension aux bornes du premier condensateur de charge (7, 51).

3. Circuit selon revendication 1, caractérisé en ce que le courant de la seconde branche (12, 13) du circuit inverseur de courant (10, 11, 12, 13) est appliqué à un amplificateur à contre-réaction.

4. Circuit selon revendication 3, caractérisé par la réalisation de l'amplificateur sous forme d'un amplificateur différentiel, comprenant un premier (21) et un second transistor (24).

5. Circuit selon revendication 4, caractérisé en ce que la seconde branche (12, 13) du circuit inverseur de courant (10, 11, 12, 13) constitue le circuit collecteur du premier transistor (21) de l'amplificateur différentiel, dont la base est reliée au premier condensateur de charge (7).

6. Circuit selon revendication 4, caractérisé en ce que les deux émetteurs des deux transistors de l'amplificateur différentiel sont reliés par une résistance (22, 38).

7. Circuit selon revendication 6, caractérisé en ce que l'émetteur d'un des deux transistors est relié à la masse par une source de courant (23).

8. Circuit selon revendication 4, caractérisé en ce que la valeur de transition entre la plage de la première valeur et la plage de la seconde valeur du courant de charge du troisième circuit de charge (8, 10, 11) est déterminée par la tension de polarisation de la base du second transistor (24) de l'amplificateur différentiel.

9. Circuit selon revendication 1, caractérisé en ce que la tension aux bornes du premier condensateur de charge (7) est limitée par un circuit limiteur (15-20).

10. Circuit selon revendication 1, caractérisé en ce que le courant du troisième circuit de charge (8, 10, 11) est pratiquement nul au-dessous du seuil de la tension aux bornes du premier condensateur de charge (7).

11. Circuit selon revendication 1, caractérisé en ce que le courant du troisième circuit de charge (8, 10, 11) est pratiquement nul au-delà du seuil de la tension aux bornes du premier condensateur de charge (51).

Fig. 1

Fig. 2

Fig. 3a

Fig. 3b

ca 25 ms | ca 25 ms

Fig. 3c

Fig. 3

Fig. 3d

Fig. 4

0 068 185